# DEMANDE DE BREVET EUROPEEN

(11) **EP 0 767 496 A1**
(43) Date de publication de la demande: **09.04.1997**
(21) Numéro de dépôt: 96402062.2
(22) Date de dépôt: 27.09.1996
(51) Int. Cl.: H01L 23/66

(54) **Circuit hyperfréquence multi-couches à éléments actifs intégrés**

(30) Priorité: 03.10.1995 FR 9511609
(71) Demandeur: DASSAULT ELECTRONIQUE, F-92214 Saint-Cloud (FR)
(72) Inventeur: Herblot, Jean-Luc, 78370 Plaisir (FR); Ledain, Bernard, 91190 Gif sur Yvette (FR)
(74) Mandataire: Plaçais, Jean-Yves

(57) **Abrégé**

Un circuit hyperfréquence comprend un empilement de couches diélectriques (Di), avec au moins une couche conductrice formant plan-masse (PMj). Des liaisons conductrices (SMk) sont prévues en au moins un niveau d'interface entre couches diélectriques (Di). L'empilement contient plusieurs plans-masse (PM1-PM5), alternés avec plusieurs niveaux de liaisons conductrices (SM1-SM4), chaque niveau de liaisons conductrices se trouvant ainsi pris en sandwich entre deux plans-masse. Des dégagements (E) découvrant un niveau de liaisons conductrices (SM4) sont également prévus en partie supérieure de l'empilement, chaque dégagement étant conformé pour loger opérativement une puce d'élément actif hyperfréquence dont les entrées/sorties et l'alimentation proviennent de niveaux inférieurs de liaisons de l'empilement, atteints par des trous métallisés (MHp), lesquels traversent des plans-masse (PMj) au niveau d'épargnes de ceux-ci.

## Description

L'invention concerne les circuits hyperfréquences.

On sait que les circuits hyperfréquence, ou micro-ondes, font appel à des technologies particulières, qui sont très différentes de celles des plus basses fréquences. En effet, il faut d'abord utiliser des conducteurs de forme particulière; il est également nécessaire de tenir compte des effets importants de rayonnement, désirés ou non; il est souhaitable enfin de limiter la taille des conducteurs, notamment pour limiter les pertes, tout en maîtrisant mieux les temps de propagation.

Les principales structures miniatures connues pour des lignes de transmission sont celles dites micro-ruban ("microstrip"), ou tri-plaque ("stripline"). Là où des composants électroniques sont nécessaires, le mieux est de recourir aux circuits intégrés hybrides hyperfréquence, ce qui est encore une autre technologie. Les liaisons doivent souvent faire intervenir des connecteurs hyperfréquence coaxiaux, notamment chaque fois que des contraintes topologiques et/ou technologiques empêchent un couplage direct.

Il résulte de ce qui précède que la conception des circuits hyperfréquence actuels est soumise d'abord à l'impératif fondamental de bon fonctionnement, tandis que les besoins tels que la miniaturisation ne sont qu'incomplètement satisfaits.

La présente invention vient améliorer la situation.

Le circuit hyperfréquence proposé est du type connu comprenant un empilement de couches diélectriques, avec au moins une couche conductrice formant plan-masse, tandis que sont prévues des liaisons conductrices, en au moins un niveau d'interface entre couches diélectriques.

Selon un aspect de l'invention, l'empilement contient plusieurs plans-masse, alternés avec plusieurs niveaux de liaisons conductrices, chaque niveau de liaisons conductrices se trouvant ainsi pris en sandwich entre deux plans-masse, en ce qu'en partie supérieure de l'empilement sont prévus des dégagements qui découvrent un niveau de liaisons conductrices, chaque dégagement étant conformé pour loger opérativement une puce d'élément actif hyperfréquence, dont les entrées/sorties et l'alimentation proviennent de niveaux inférieurs de liaisons de l'empilement, atteints par des trous métallisés, lesquels traversent des plans-masse au niveau d'épargnes de ceux-ci.

Dans un mode de réalisation, le dispositif comprend au moins trois niveaux de liaisons conductrices, pris en sandwich entre quatre plans-masse.

De préférence, les puces sont collées sur la couche diélectrique sur laquelle elles reposent, celle-ci étant avantageusement en un matériau du type verre-téflon.

D'autres caractéristiques et avantages de l'invention apparaîtront à l'examen de la description détaillée ci-après, ainsi que des dessins annexés, sur lesquels :
- la figure 1 est une coupe schématique de principe d'un circuit hyperfréquence multi-couches selon la présente invention;
- la figure 2 montre comment l'on peut implanter une puce de circuit hyperfréquence actif dans une structure du type de celle de la figure 1; et
- la figure 3 est un diagramme de principales étapes de fabrication d'un circuit hyperfréquence multi-couches tel que proposé.

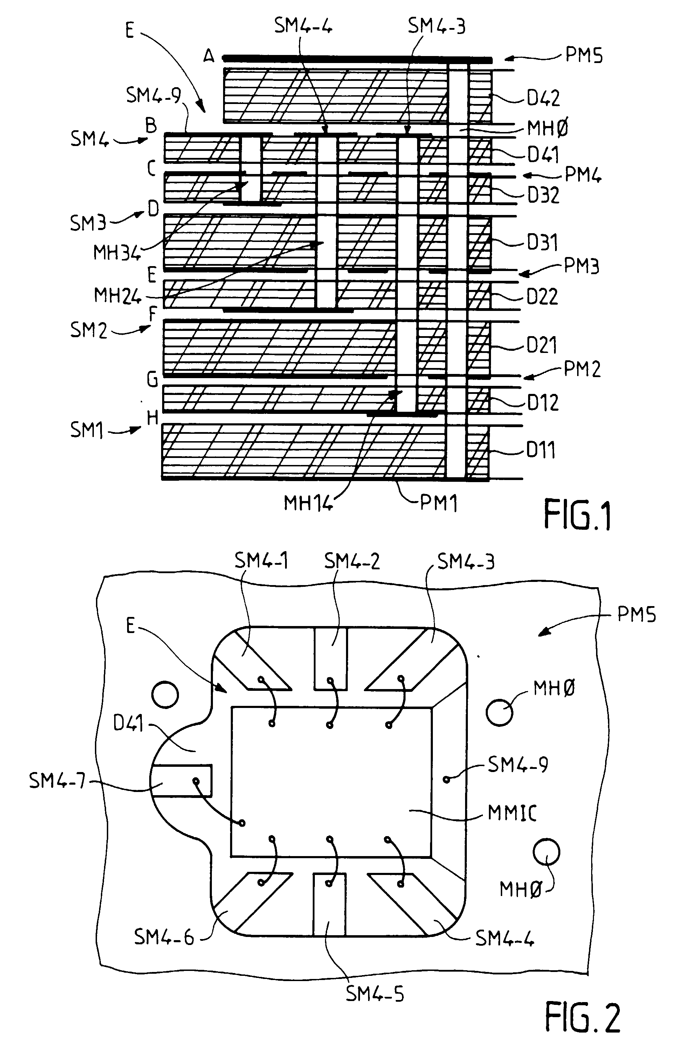

La figure 1 sera maintenant décrite, de bas en haut. Une première couche diélectrique D11 porte en partie basse un plan-masse PM1, défini par une métallisation surajoutée à la couche. Entre la couche D11 et une seconde couche diélectrique D12 est placé un niveau de métallisation sélective SM1, qui pourra servir de ligne de liaison. Une troisième couche diélectrique D21 porte en partie inférieure un plan-masse PM2, évidé pour former des épargnes là où il est traversé par des trous métallisés tels que MH14.

A partir du plan-masse PM2, la structure se répète ensuite avec la couche diélectrique D21, le niveau de métallisation sélective SM2, la couche diélectrique D22, et le plan-masse PM3.

Ceci se répète une troisième fois avec la couche diélectrique D31, le niveau de métallisation sélective SM3, la couche diélectrique D32, et le plan de masse PM4.

Avantageusement, ceci se répète une quatrième fois avec la couche diélectrique D41, le niveau de métallisation sélective SM4, la couche diélectrique D42 et le plan-masse supérieur PM5, qui est ici illustré à une certaine distance au-dessus de la couche diélectrique D42 (dans le seul but d'améliorer la lisibilité du dessin).

Des trous métallisés tels que MH0 traversent complètement la structure de part en part, pour aller du plan-masse PM1 au plan-masse PM5, en se reliant à chaque fois aux plans-masse intermédiaires PM2, PM3, PM4.

D'autres trous métallisés, tels que MH14, MH24 ou MH34 relient des niveaux de liaisons conductrices l'un à l'autre. Dans ce second cas, les trous métallisés ne viennent en principe pas au contact des plans-masse, sauf là où c'est désiré. Ainsi par exemple, le trou métallisé MH14 relie une ligne conductrice du niveau SM1 à une ligne conductrice du niveau SM4.

Le trou métallisé MH24 relie une ligne du niveau SM2 à une ligne du niveau SM4. Et le trou métallisé MH34 relie une ligne du niveau SM3 à une ligne du niveau SM4.

La dernière des couches diélectriques, ici la couche D42, est échancrée pour définir un dégagement, qui découvre le niveau sous-jacent de liaisons conductrices. Chaque dégagement est conformé en fonction de la géométrie d'une puce d'élément actif hyperfréquence (ou d'élément passif), la définition de la conformation étant ici considérée comme accessible à l'homme du métier.

L'alimentation de la puce va provenir d'un autre niveau de liaison de l'empilement, atteint par des trous métallisés. Certaines au moins des entrées, sorties, ou entrées/sorties de la puce peuvent également provenir d'un niveau inférieur de liaison, au moins là où des croisements de liaisons sont nécessaires.

Ainsi, la figure 2 illustre dans l'échancrure E une puce MMIC qui comporte trois bornes d'entrées/sorties reliées par fil soudé ("ball bonding") à des lignes conductrices que l'on distingue en SM4-1 à SM4-6. L'alimentation est assurée par une liaison sur une autre ligne SM4-7, tandis que la masse de la puce est ici définie par son fond relié au conducteur sous-jacent SM-9 par une colle conductrice. En variante, la masse peut être amenée par une autre connexion latérale.

La figure 2 fait encore apparaître des trous métallisés traversants indiqués en MH0.

La structure qui vient d'être décrite peut être considérée comme la combinaison de quatre systèmes tri-plaques ("stri-pline") superposés, à laquelle sont incorporées d'une manière nouvelle les puces actives ou bien des éléments passifs d'une technologie différente.

Il apparaît que les deux ou trois niveaux sous-jacents permettent de réaliser les interconnexions voulues, tant pour la borne active d'alimentation que pour les lignes de signal, sans qu'il soit nécessaire de donner un exemple détaillé de telles interconnexions. Les entrées/sorties du circuit (signal et/ou alimentation) peuvent être définies par un ou plusieurs connecteurs latéraux (non représentés). Ces connecteurs peuvent être montés comme les composants, le cas échéant.

De préférence, le matériau diélectrique est celui connu sous le nom de Duroïd 6002 (Marque déposée), dans une épaisseur de 0,127 mm, vendu par la Société Rogers Corporation. Ce matériau possède une constante diélectrique de 2,9 à 10 GHz, pour un facteur de dissipation de 0,013 à la même fréquence. Ces coefficients de dilatation thermique sont de 16 ppm/°K dans les directions X et Y, c'est-à-dire dans son plan, contre 24 ppm/°K dans la direction Z, c'est-à-dire perpendiculairement à son plan.

La Demanderesse a observé qu'il est possible d'utiliser ce matériau pour réaliser des lignes de transmission espacées de largeur 100 µm, possédant entre elles un espacement qui est également de 100 µm, ces dimensions étant ajustables selon l'impédance désirée. Les trous traversants peuvent être réalisés à un diamètre de 0,3 mm, pour se relier à des métallisations dont la taille mimimale est celle du diamètre du trou augmentée de 0,3 mm.

La Demanderesse a encore observé que le matériau résiste très bien à des cycles nombreux de variations rapides de températures.

Il a encore été observé que, pour assurer dans des conditions correctes le perçage et la métallisation, le diamètre des trous doit être au moins égal à environ 1/5ème de l'épaisseur des couches traversées.

C'est alors qu'il a été remarqué que le dispositif proposé, plus spécialement avec le matériau qui vient d'être indiqué, peut conduire à une structure particulièrement compacte, ce qui présente des avantages manifestes dans le domaine des hyperfréquences.

Il a encore fallu résoudre le problème de la réalisation matérielle du dispositif.

Le point de départ consiste en des couches de Duroïd 6002, dont l'épaisseur est soit de 0,127, soit de 0,254 mm. Ces couches sont munies d'une métallisation de cuivre dont l'épaisseur est de 35 µm, par exemple.

Plusieurs structures identiques peuvent être réalisées dans un même panneau, qui est ensuite découpé.

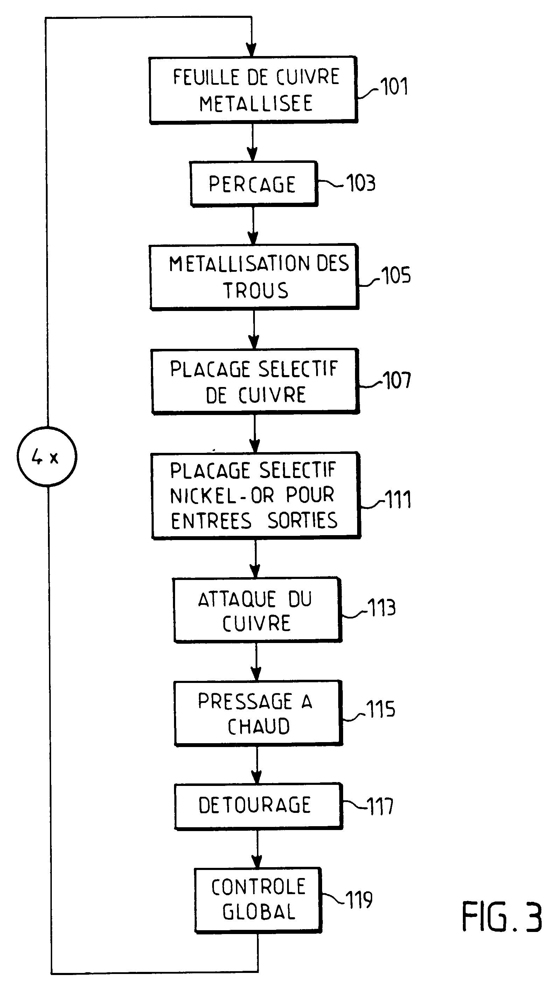

La figure 3 Illustre la suite des étapes du procédé de fabrication, pour chacune des structures tri-plaques que comprend le dispositif.

L'étape 101 part de la feuille de cuivre métallisée qui vient d'être définie.

L'étape 103 consiste en son perçage aux endroits voulus.

L'étape 105 consiste en la métallisation des trous.

L'étape 107 consiste en une recharge sélective de cuivre ("pattern plating"), ajoutant par exemple au moins 25 µm aux 35 µm de cuivre déjà déposés.

L'étape 111 consiste en un placage sélectif nickel-or pour les entrées/sorties de la puce, de préférence également pour celles du circuit).

L'étape 113 consiste dans l'attaque du cuivre, aux endroits voulus soit pour laisser place aux trous traversants, soit pour assurer les lignes de transmission.

L'étape 115 consiste en un pressage à chaud (autoclave), pour assurer la liaison à haute température des couches, qui se lient par fusion.

L'étape 116 consiste en un détourage de l'extérieur du circuit et des emplacements de puces ou autres composants. Ce détourage est effectué par exemple à la fraise ou par usinage au laser.

A l'étape ultime 119, un contrôle global est effectué sur le sandwich tri-plaque qui vient d'être obtenu, l'ensemble du processus étant répété quatre fois pour obtenir le dispositif de la figure 1.

En principe, le placage électrolytique au nickel et à l'or est effectué non seulement pour les entrées/sorties, mais aussi pour les plots de soudure par fil de la puce.

Des métallisations latérales peuvent également être effectuées sur les côtés de la structure, avant qu'elle ne soit découpée en circuits individuels, et/ou du côté de l'entrée/sortie.

Les échancrures destinées à recevoir les puces ou éléments passifs sont découpées a priori (avant le pressage de l'étape 115) dans la couche diélectrique supérieure de l'élément tri-plaque supérieur. De telles échancrures ou dégagements permettent de loger par exemple des composants passifs, ou bien des puces miniatures hyperfréquence à base d'arséniure de gallium, qui sont directement fixées par une colle époxy conductrice pour micro-électronique (comme la colle H20E de la société EPOTECNY des Etats-Unis), sur une zone munie d'une métallisation épaisse de 70 µm. Deux trous aveugles placés sous la puce permettent la connexion de masse.

La soudure par fil sur les bornes de la puce est effectuée après la polymérisation de la colle. On utilise de préférence un procédé de soudure thermosonique à l'or ("Thermosonic gold ball bonding"), avec un diamètre de fil de 25 µm.

Une variante consiste à effectuer une soudure par ruban thermosonique de 75 µm de large, ce qui peut autoriser une boucle plus courte et une inductance plus faible.

Une structure telle que celle qui vient d'être décrite, avec le matériau indiqué, possède de très bons résultats en termes de performances électriques et de contraintes dimensionnelles. Comme déjà indiqué, ceci constitue un pas important vers la solution du problème posé.

## Revendications

1. Circuit hyperfréquence, du type comprenant un empilement de couches diélectriques, avec au moins une couche conductrice formant plan-masse, tandis que sont prévues des liaisons conductrices, en au moins un niveau d'interface entre couches diélectriques,
caractérisé en ce que l'empilement contient plusieurs plans-masse, alternés avec plusieurs niveaux de liaisons conductrices, chaque niveau de liaisons conductrices se trouvant ainsi pris en sandwich entre deux plans-masse, en ce qu'en partie supérieure de l'empilement sont prévus des dégagements qui découvrent un niveau de liaisons conductrices, chaque dégagement étant conformé pour loger opérativement une puce d'élément actif hyperfréquence, dont les entrées/sorties et l'alimentation proviennent de niveaux inférieurs de liaisons de l'empilement, atteints par des trous métallisés, lesquels traversent des plans-masse au niveau d'épargnes de ceux-ci.

2. Dispositif selon la revendication 1, caractérisé en ce qu'il comprend au moins trois niveaux de liaisons conductrices, pris en sandwich entre quatre plans-masse.

3. Dispositif selon l'une des revendications 1 et 2, caractérisé en ce que les couches diélectriques sont réalisées dans un matériau du type verre-téflon.
